# EUROPÄISCHE PATENTANMELDUNG

(11) **EP 4 294 135 A1**
(43) Veröffentlichungstag der Anmeldung: **20.12.2023**
(21) Anmeldenummer: 22178969.6
(22) Anmeldetag: 14.06.2022
(51) Int. Cl.: H05K 3/20, H01L 23/15, H05K 1/03

(54) **METALLISCHE STRUKTUR ALS VORPRODUKT FÜR ELEKTRISCHE SCHALTUNGEN UND VERFAHREN ZUR HERSTELLUNG EINER ELEKTRISCHEN SCHALTUNG**

(71) Anmelder: CeramTec GmbH, 73207 Plochingen (DE)
(72) Erfinder: DILSCH, Roland, 95199 Thierstein (DE); LENEIS, Roland, 95615 Marktredwitz (DE)

(57) **Zusammenfassung**

Die vorliegende Erfindung beschreibt eine einteilige flächenförmige metallische Struktur (3) und ein Verfahren zur Herstellung einer elektrischen Schaltung auf einem Substrat (2) unter Verwendung dieser Struktur (3).

Erfindungsgemäß wird eine einteilige flächenförmige metallische Struktur (3) hergestellt, die als Vorprodukt für elektrische Schaltungen aus Leiterbahnen (5) und/oder Leiterflächen, im Folgenden Metallisierungsbereiche (5) genannt, besteht. Zwischen den Metallisierungsbereichen (5) sind an geeigneten Stellen Verbindungsstege (6) für die Stabilisierung und Handhabbarkeit der Struktur (3) angeordnet.

Das erfindungsgemäße Verfahren zur Herstellung einer elektrischen Schaltung auf einem Substrat (2) ist dadurch gekennzeichnet, dass die einteilige flächenförmige metallische Struktur (3) ausschließlich mittels ihrer Metallisierungsbereiche (5) auf dem Substrat (2) befestigt wird und anschließend die Verbindungsstege (6) der Struktur (3) entfernt werden.

## Beschreibung

Die vorliegende Erfindung beschreibt eine einteilige, flächenförmige, metallische Struktur nach dem Oberbegriff des Anspruchs 1, und ein Verfahren zur Herstellung einer elektrischen Schaltung auf einem Trägerkörper unter Verwendung dieser Struktur.

Wenn im Folgenden von Metallisierungen die Rede ist, so werden metallische Leiterbahnen und/oder Leiterflächen verstanden, die voneinander elektrisch entkoppelt sein müssen, damit es zu keinem Kurzschluss kommt. Jede elektrische Schaltung besteht aus Metallisierungen, die zur Stabilität und Wärmeabfuhr auf einem Trägerkörper angeordnet sind. Auf diesen Metallisierungen sind die elektrischen oder elektronischen Komponenten angeordnet bzw. verbunden. Je nach Anwendungsfall gibt es Trägerkörper aus den unterschiedlichsten elektrisch nichtleitenden Materialien. Wenn eine besonders gute Wärmeableitung erforderlich ist, haben sich Trägerkörper aus einer Keramik als besonders effektiv erwiesen. Derartige Trägerkörper werden auch als Substrate bezeichnet.

Das Design der Metallisierungen orientiert sich dabei in der Regel an einem Leiterbahnendesign. Die Metallisierung dient zusätzlich der Wärmespreizung unter den Wärmequellen, d.h. der Komponenten bzw. Bauteile (z.B. Halbleiter) auf der Schaltung und reduziert dadurch den thermischen Widerstand.

Zur Herstellung von Schaltungen auf einem Substrat aus einer Keramik wird insbesondere eine Metallisierung aus Kupfer verwendet. Zum Aufbringen wird üblicherweise die (1) DCB- oder die (2) AMB-Technik angewendet.
(1) Direct Copper Bonded (DCB) ermöglicht eine enge elektrische oder thermische Verbindung elektronischer Bauteile. Dazu wird ein Kupferblech (ca. 300 µm) an der Oberfläche oxidiert und dann nahe dem Schmelzpunkt des Kupfers vollflächig mit der Keramik in Verbindung gebracht. Es bilden sich Spinelle aus, die für die Haftung des Kupfers an der Keramik verantwortlich sind. Um beide Seiten eines keramischen Substrates zu metallisieren, wird der Prozess mindestens einmal pro Seite ausgeführt. Die Strukturierung des Kupfer-Blechs geschieht durch nass-chemisches Ätzen. Das DCB-Verfahren ist günstig. Die zu verwendenden Keramiken Aluminiumoxid und oberflächlich oxidiertes Aluminiumnitrid zeigen allerdings nur eine beschränkte Temperaturwechselfestigkeit. Das Kupfer-Blech, das mittels DCB mit dem keramischen Substrat verbunden ist, bildet die Trägerschicht der elektrischen Bauelemente.
(2) Mit Aktivlöten (AMB, Activ Metal Brazing) werden metallisierte Keramikbauteile mit Metalllot und Metallteilen verbunden. Dem Lot ist dabei ein Aktivelement zugefügt oder der Fügepartner ist selbst eine Aktivelement-Legierung. Aktivelemente sind dabei u.a. Titan oder Indium, die beim Löten mit dem Sauerstoff der Keramik reagieren. Dieses Verfahren ist im Vergleich zur DCB-Technik teurer, da hier ein Vakuumprozess notwendig ist oder ein Schutzgas verwendet werden muss. Vorteilhaft ist, dass hiermit vollflächig Kupferbleche auch auf Siliziumnitrid aufgelötet werden können. Siliziumnitrid sorgt mit seiner hohen Risszähigkeit für eine hohe Temperaturwechselbeständigkeit des Bauteils. Auch hier entsteht die Struktur des Kupfer-Blechs durch nasschemisches Ätzen.

Beim DCB-Verfahren (1) werden unstrukturierte, voroxidierte Kupferbleche in der bevorzugten Dicke von 0,3 - 1,0 mm auf Substrate aus z.B. Oxidkeramiken, wie Al2O3 oder oberflächlich oxidierte Nichtoxidkeramiken wie AIN oder Si3N4 aufgebracht und einer Temperaturbehandlung bei etwa 1065-1080°C unterzogen. An der Grenzfläche zwischen Kupfer/Kupferoxid und Keramik entsteht eine elektrisch nicht leitfähige Kupfer-Aluminium-Oxidschicht. Im nachfolgenden Schritt wird mittels Siebdruck ein Ätzresist auf das Kupfer aufgebracht. In einem Ätzschritt, zumeist mit FeCl3, Na2S2O8 und HCl, wird der nicht mit dem Ätzresist versehene Bereich des Kupferblechs entfernt und das Kupferblech somit strukturiert. Anschließend wird der Ätzresist wieder entfernt, bevorzugt chemisch, und das DCB- Substrat kann in nachfolgenden Schritten weiter galvanisch mit Nickel, Palladium und/oder Gold veredelt werden.

Beim AMB-Verfahren (2) werden unstrukturierte Kupferbleche auf eine siebgedruckte und eventuell vorgesinterte Schicht aus einem Aktivlot, z.B. AgCuTi4 oder anderen Zusammensetzungen mit aktiven (sauerstoff- oder stickstoffsuchenden) Elementen wie Ti oder Zr aufgebracht und der Verbund je nach Lot bei etwa 600-1000°C gesintert.

Vollflächige Aktivlötungen sind im Stand der Technik bekannt. Soll das Kupferblech allerdings entsprechend einem Design, z.B. einem Leiterbahnendesign, strukturiert werden, muss, ähnlich zum DCB-Verfahren (1), mit einem Ätzverfahren der unerwünschte Bereich der Metallisierung entfernt werden. Auch hier wird zunächst der gewünschte Bereich mit einem Ätzresist, häufig aufgebracht mittels Siebdruck, geschützt, und anschließend in einem Ätzschritt die unerwünschte Metallisierung sowie das elektrisch leitfähige Aktivlot entfernt. Anschließend wird auch hier der Ätzresist wieder entfernt, üblicherweise chemisch mit einer alkalischen Lösung von Natriumcarbonat oder Natriumhydroxid. Der Verbund kann dann bei Bedarf weiter veredelt werden.

Die nach AMB-Verfahren (2) aufgebrachten Verbindungsschichten zwischen Kupferschicht und Keramik sind im Unterschied zu nach dem DCB-Verfahren (1) aufgebrachten Schichten, porenfrei an die Keramik gebunden, d.h. es sind wenige bis keine Löcher in dem Aktivlot. Sind, wie bei DCB, Poren bzw. Löcher vorhanden, entstehen bei höheren Spannungen Teilentladungen, die die Keramik zerstören können. Die aufgrund der geringen Anzahl an Poren vorliegende hohe Dichte bewirkt eine höhere Teilentladungsfestigkeit bei AMB. Diese wirkt sich vorteilhaft auf einen Betrieb bei hohen Spannungen aus. Nachteilig ist aber, dass im Ätzschritt auch das chemisch schwer angreifbare Aktivlot entfernt werden muss. Dazu werden sehr aggressive Chemikalien wie HNO3, HF, H2SiF6 benötigt.

Der Erfindung liegt die Aufgabe zugrunde, die Herstellung von elektrischen Schaltungen zu vereinfachen. Dabei soll ein Vorprodukt vorgeschlagen werden, welches alle für die Schaltung erforderlichen Metallisierungen enthält, und einfach zu handhaben ist. Außerdem soll ein Verfahren angegeben werden, mit dem auf einfache Weise das Vorprodukt bzw. dessen Metallisierungen auf einem Trägerkörper befestigt werden kann. Wenn als Trägerkörper ein Substrat aus einer Keramik verwendet wird, sollen sich die Metallisierungen unter Vermeidung aggressiver Chemikalien aufbringen lassen. Das Verfahren soll die Nachteile des Standes der Technik überwinden und einfach und kostengünstig durchzuführen sein.

Diese Aufgabe wird durch eine einteilige, flächenförmige, metallische Struktur gelöst, die als Vorprodukt für elektrische Schaltungen aus Leiterbahnen und/oder Leiterflächen, im Folgenden Metallisierungen genannt, besteht wobei zwischen den Metallisierungen an geeigneten Stellen Verbindungsstege und/oder Verbindungsflächen für die Stabilisierung und Handhabbarkeit der Struktur angeordnet sind. Diese Struktur enthält alle für die Schaltung erforderlichen Metallisierungen, und ist einfach zu handhaben. Mit "alle für die Schaltung erforderlichen Metallisierungen" sind alle wesentlichen Metallisierungen gemeint. Durch die Verbindungsstege und/oder Verbindungsflächen, im Folgenden gemeinsam als Verbindungssteg bezeichnet, haben die Metallisierungen einen Zusammenhalt, so dass die Struktur insgesamt leicht zu handhaben ist. Zugleich geben die Verbindungsstege auch den Abstand der Metallisierungen voneinander vor, d.h. wird ein größerer Abstand gewünscht, müssen die Verbindungsstege entsprechend angepasst werden. Die einteilige, flächenförmige, metallische Struktur kann auch Erhebungen oder Einbuchtungen aufweisen, ganz so wie der später beschriebene Trägerkörper aufgebaut ist.

Die Struktur besteht bevorzugt aus Kupfer oder aus kupferhaltigen Legierungen, kann aber auch aus Aluminium oder aluminiumhaltigen Legierungen bestehen. Selbstverständlich sind alle Metalle möglich, die für elektrische Schaltungen geeignet sind.

In einer bevorzugten erfindungsgemäßen Ausführungsform ist der Raum zwischen den Metallisierungen vollständig mit Verbindungsstegen ausgefüllt, so dass die Struktur eine geschlossene Fläche ohne Durchbrüche bildet. Diese erfindungsgemäße Ausführungsform kann auch als geschlossene Folie bezeichnet werden. Durch das vollständige Fehlen von Durchbrüchen ist die Handhabbarkeit maximiert.

Bevorzugt stellen die Metallisierungen der Struktur eine einzige oder eine Mehrzahl an elektrischen Schaltungen dar. Dies ist besonders für die Produktion von vielen Schaltungen vorteilhaft.

In einer weiteren bevorzugten Ausführungsform weisen einzelne Metallisierungen bzw. Verbindungsstege eine gleiche oder geringere Dicke als die anschließenden Metallisierungen auf. Dies bedeutet, dass es unterschiedliche Dicken der Verbindungsstege geben kann.

Die Verbindungsstege können zur Oberseite und/oder Unterseite der Struktur einen Abstand aufweisen, und dieser kann unterschiedlich und auch Null sein, d.h. die Verbindungsstege können zu einer Seite bündig angeordnet sein und zur anderen Seite einen Abstand aufweisen.

Insgesamt können die Metallisierungen eine voneinander unterschiedliche Dicke aufweisen, je nach den Anforderungen der Schaltung.

Bevorzugt beträgt der Abstand zwischen zwei benachbarten Metallisierungen mindestens 50 µm, damit sich diese nicht gegenseitig beeinflussen. Bevorzugt wird der Abstand, den benachbarte Metallisierungen aufweisen, durch die Isolationsspannung bestimmt.

Ein erfindungsgemäßes Verfahren zur Herstellung einer elektrischen Schaltung auf einem Trägerkörper unter Verwendung der eben beschriebenen einteiligen flächenförmigen metallischen Struktur zeichnet sich dadurch aus, dass die Struktur ausschließlich mittels ihrer Metallisierungen auf dem Trägerkörper befestigt wird und anschließend die Verbindungsstege der Struktur entfernt werden. Es bleiben danach nur noch die Metallisierungen auf dem Trägerkörper übrig.

Der Trägerkörper ist bevorzugt ein Substrat aus einer Keramik. Welche Keramiken geeignet sind, wird weiter unten beschrieben. Keramik kann entstehende Wärme sehr schnell und effektiv weiterleiten und eignet sich daher besonders gut.

Bevorzugt wird die Struktur auf dem Substrat an den Metallisierungen mit dem an sich bekannten AMB-Verfahren befestigt.

Hierbei werden besonders bevorzugt ausschließlich die Flächen auf dem Substrat, auf denen die Metallisierungen der Struktur befestigt werden sollen, mit Aktivlot versehen. Alternativ können die Metallisierungen der Struktur auch auf der zum Substrat gewandten Seite mit Aktivlot versehen werden.

Eine bevorzugte Ausführungsform des erfindungsgemäßen Verfahrens zur Herstellung einer elektrischen Schaltung auf einem Substrat aus einer Keramik mit dem AMB-Verfahren umfasst folgende Verfahrensschritte:
a) Bereitstellen der Struktur mit Metallisierungen und Verbindungsstegen und des Substrats,
b) Aufbringen des Aktivlots ausschließlich auf den Flächen des Substrats, auf denen die Metallisierungen der Struktur befestigt werden sollen oder auf die Metallisierungen der Struktur auf der zum Substrat gewandten Seite,
c) Gerichtetes Aufbringen und Fixieren der Struktur auf das Substrat, so dass nur die Metallisierungen der Struktur über das Aktivlot mit den zu metallisierenden Flächen des Substrats in Verbindung stehen,
d) Temperaturbehandlung des gesamten Verbunds bei Temperaturen oberhalb der Aktivierungstemperatur des Aktivlots zur Erzeugung der Verbindung Metallisierungen - Aktivlot - Substrat,
e) Entfernen der Verbindungsstege,
f) Entnahme des Verbunds.

Nachfolgend werden weitere Vorteile und auch vorteilhafte Ausgestaltungen der Erfindung erläutert. Allgemein ist zu sagen, die Unteransprüche geben bevorzugte Ausgestaltungen wieder. Ausgestaltungen können frei miteinander kombiniert werden.

Alle %-Angaben sind als Gewichts-%-Angaben zu verstehen, es sei denn, es wird anderweitig spezifiziert.

Erfindungsgemäß wird eine Struktur als Vorprodukt vorgeschlagen. Diese Struktur kann auch als Metalldesign bezeichnet werden. Auch wird ein Verfahren zur Herstellung einer elektrischen Schaltung auf einem Trägerkörper bzw. zur Herstellung eines Verbundes umfassend ein Substrat und darauf aufgebracht mindestens zwei Metallisierungen vorgeschlagen, wobei vorteilhaft in einer Ausgestaltung des Verfahrens die Metallisierungen mittels Aktivlot auf einem Substrat aus Keramik befestigt sind. Das Verfahren dient dem Aufbringen mindestens zweier Metallisierungsflächen entsprechend einem Designlayout auf ein Substrat. Bevorzugt stellt das Verfahrensprodukt eine Leiterplatte dar, deren Substrat z.B. eine Keramik ist, und die mindestens zwei Metallisierungen stellen zwei Leiterbahnen oder Leiterflächen dar.

In einer Ausgestaltung besteht das Verfahrensprodukt somit aus mindestens einem Substrat, mindestens einem Aktivlot und mindestens zwei Metallisierungsflächen.

Das Substrat ist der Trägerkörper und Untergrund für die darauf haftenden, leitenden Metallisierungen. Bevorzugt handelt es sich dabei um eine Leiterplatte. Das Substrat ist aus einem elektrisch isolierenden Material und besteht bevorzugt aus keramischen Materialien. Besonders bevorzugt werden Oxidkeramiken oder Nichtoxidkeramiken eingesetzt. Insbesondere bevorzugt eingesetzte Keramiken sind Aluminiumoxid von 90% bis 99,99% Reinheit, Aluminiumnitrid von 90% bis 99,99% Reinheit, Siliciumnitrid von 90% bis 99,99% Reinheit oder Mischungen daraus. Das Substrat kann einseitig oder beidseitig mit Metallisierungen versehen werden und/oder auch Durchkontaktierungen beinhalten. In einer weiteren Ausgestaltung liegt ein Verbund aus mehreren gleichen oder unterschiedlichen Substraten vor, wobei sich auf den einzelnen Substraten bevorzugt Leiterbahnen befinden.

Die Dicke des Substrats beträgt bevorzugt 50-2000 µm, besonders bevorzugt 250-1500 µm und insbesondere bevorzugt 300-1250 µm. Die Abmessungen (Länge x Breite) orientieren sich bevorzugt am Industriestandard und betragen besonders bevorzugt 150 - 250 mm x 100 -160 mm, insbesondere bevorzugt 180 - 200 mm x 130 - 145 mm.

Ebenheit, Rauigkeit, Krümmung spielt keine Rolle und ist im Rahmen der Standardspezifikation gegeben.

Der Begriff Metallisierung bezeichnet unter anderem eine metallische Beschichtung (Aktivlot) und mindestens eine Metallschicht, die auf ein Substrat aufgebracht ist und im finalen Produkt bevorzugt die mindestens zwei Leiterbahnen darstellt. Erfindungsgemäß handelt es sich bei der Metallisierung bevorzugt um eine Metallisierung aus Kupfer und/oder Aluminium, besonders bevorzugt eine Schicht aus Kupfer.

Die Metallisierung kann ein oder mehrere Leiterbereiche enthalten für die gilt: Kantenlänge a<b und/oder ein oder mehrere großflächige Elemente für die gilt: Kantenlängen c»a und Kantenlänge d ungefähr gleich oder größer c. In einer Ausgestaltung liegt mehr als eine Metallisierung im finalen Produkt vor, bevorzugt mehr als eine Leiterbahn. In einer besonderen Ausgestaltung ist die Dicke der mehr als einen Metallisierung im finalen Produkt voneinander unterschiedlich, d.h. bevorzugt weisen die einzelnen Metallisierungen unterschiedliche Dicken auf.

Die Metallisierung wird bevorzugt aus einem Metallblech, d.h. einer speziellen Ausgestaltung der einteiligen, flächenförmigen, metallischen Struktur, erzeugt. Ein Metallblech ist ein Blech aus einem Metall, einer Legierung oder einem Gemisch mehrerer Metalle, dessen Breite und/oder Länge sehr viel größer als dessen Dicke ist. Bevorzugt handelt es sich bei dem Metallblech um ein Kupferblech oder ein Aluminiumblech, besonders bevorzugt um ein Kupferblech.

Das Metallblech ist 10 - 2000 µm dick, bevorzugt 100 - 1500 µm dick, besonders bevorzugt 250 - 1000 µm, insbesondere bevorzugt 300 - 500 µm dick. Die Länge und Breite des Metallblechs kann von wenigen mm bis zur Größe des Keramiksubstrates und sogar darüber hinaus reichen.

Das Metallblech weist in einer Ausgestaltung eine Krümmung auf, die sich bevorzugt an der Krümmung des Substrats orientiert und mit dieser gleich verläuft. In einer bevorzugten Ausgestaltung ist das Metallblech eben.

Das Metallblech weist mindestens zwei Bereiche auf, nämlich
- Mindestens einen Bereich, der im finalen Produkt eine Metallisierung, bevorzugt eine Leiterbahn darstellt. Dieser Bereich wird im Folgenden als Metallisierungsbereich bezeichnet. Bevorzugt liegen mehr als ein Leiterbahnenbereich vor, d.h. bevorzugt befindet sich im finalen Produkt mehr als eine Leiterbahn auf einer Leiterplatte.
- Mindestens einen Bereich, der nur der reinen Handhabbarkeit dient und die Metallisierungsbereiche miteinander verbindet und/oder einen Metallisierungsbereich mit komplexer Form für das nachfolgend beschriebene Verfahren stabil handhabbar macht. Im Folgenden wird dieser Bereich als Verbindungssteg und/oder Verbindungsfläche bezeichnet. Im finalen Produkt ist in diesem Bereich das Metallblech nicht mehr vorhanden, d.h. in diesen Bereichen befindet sich im finalen Produkt keine Metallisierung.

Diese Bereichseinteilung orientiert sich an dem finalen Designlayout der Metallisierung auf dem Substrat, bevorzugt der Leiterbahnen auf der Leiterplatte.

Das Metallblech ist in einer bevorzugten Ausgestaltung strukturiert, d.h. es weist lokale Ausdünnungen auf. Das Metallblech weist bevorzugt lokale Ausdünnungen auf der dem Substrat zugewandten Seite auf, in einer besonders bevorzugten Ausgestaltung weist das Substrat Ausdünnungen sowohl auf der dem Substrat zugewandten als auch auf der dem Substrat abgewandten Seite auf.

Ggf. weist das Metallblech auch Bereiche auf, in denen das Metallblech vollständig entfernt ist, im Folgenden als Hohlstellen bezeichnet. In diesen Bereichen befindet sich im finalen Produkt ebenfalls keine Metallisierung.

Metallisierungsbereiche sind dabei die Bereiche des Metallblechs, die maximal der Dicke des Metallblechs entsprechen und minimal eine Dicke von 10 µm, bevorzugt von 100µm, besonders bevorzugt von 300 µm aufweisen. Die Metallisierungsbereiche verbleiben nach dem Durchführen des erfindungsgemäßen Verfahrens auf dem Substrat. In einer Ausgestaltung weist das Metallblech lokale Ausdünnungen auf der im finalen Produkt vom Substrat abgewandten Seite auf. Mit dieser Ausgestaltung können Metallisierungsbereiche mit unterschiedlichen Dicken (DM1, DM2, ..., DMn) erzeugt werden.

Die Dicke der Metallisierungsbereiche entspricht bevorzugt der Dicke der Metallisierung. In einer Ausgestaltung wird im Anschluss des Verfahrens zumindest teilweise die Dicke der Metallisierungsbereiche reduziert, um Metallisierungen mit geringerer Höhe zu erzeugen. Diese Ausgestaltung ist mit der Ausgestaltung der lokalen Ausdünnungen auf der vom Substrat abgewandten Seite kombinierbar.

Die Verbindungsstege und/oder Verbindungsfläche dienen dazu, Metallisierungsbereiche miteinander zu verbinden oder einen einzelnen Metallisierungsbereich derart zu stabilisieren, dass seine Handhabbarkeit gegeben ist. Es handelt sich dabei um Metallstege, die sich an die Metallisierungsbereiche anschließen, d.h. mit diesen verbunden sind. Diese Verbindungsstege werden nach dem Fixieren der Metallisierungsbereiche auf dem Substrat entfernt.

Zwei durch einen Verbindungssteg verbundene Metallisierungsbereiche dürfen minimal 50µm Abstand haben.

Der Verbindungssteg ist in einer Ausgestaltung genauso dick wie der dünnste Metallisierungsbereich, an den er sich anschließt. In einer bevorzugten Ausgestaltung ist ein Verbindungssteg dünner als der Metallisierungsbereich, d.h. seine Dicke ist geringer als die des Metallisierungsbereichs, mit dem er verbunden ist. Bevorzugt ist er ≤ 0,7 mal so dick wie der Metallisierungsbereich, mit dem er verbunden ist, besonders bevorzugt ≤0,5 mal so dick und insbesondere bevorzugt ≤ 0,3 mal so dick. In einer bevorzugten Ausgestaltung ist der Verbindungssteg jedoch nicht dünner als 50 µm, bevorzugt weist er eine minimale Dicke von 100µm auf. Verbindet ein Verbindungssteg unterschiedlich dicke Metallisierungsbereiche orientiert sich die Dicke am dünnsten Metallisierungsbereich.

Ein Verbindungssteg ist in einer Ausgestaltung eine lokale Ausdünnung des Metallblechs auf der im finalen Produkt dem Substrat zugewandten Seite. In einer weiteren Ausgestaltung stellt ein Verbindungssteg eine lokale Ausdünnung sowohl auf zum Substrat gerichteten als auch auf der vom Substrat abgewandten Seite dar. Beide Ausgestaltungen können nebeneinander vorliegen. Die Dicke (DV1, DV2, ..., DVn) der Verbindungsstege kann somit gleich oder voneinander verschieden sein. In beiden Ausgestaltungen liegt der Verbindungssteg, wenn das derart strukturierte Metallblech auf das Substrat aufgebracht wird, nicht auf dem Substrat auf, bevorzugt weder auf dem Aktivlot noch auf dem Substrat.

Unter Verbindungssteg wird immer auch eine Verbindungsfläche verstanden.

Die substratseitigen und substratabgewandten Ausnehmungen werden mechanisch, bevorzugt durch Umformen, durch Fräsen, mittels eines Stichels, optisch (bevorzugt durch einen Laser), und/oder chemisch erzeugt. Das chemische Erzeugen der Ausnehmungen erfolgt bevorzugt durch strukturiertes Ätzen mit einem Ätzmittel. Dabei wird ein Ätzresist auf die Bereiche aufgebracht, die keine Ausnehmungen ergeben sollen, um diese vor dem Ätzmittel zu schützen. Bevorzugt erfolgt der Auftrag mittels Siebdrucks. Anschließend wird ein Ätzmittel, bevorzugt FeCl3 und HCl auf die zu ätzende Fläche, die später eine Ausnehmung darstellen soll, oder auf das gesamte Metallblech aufgebracht. Die nicht mit dem Ätzresist bedeckten Flächen werden durch das Ätzmittel zumindest teilweise entfernt. Nachdem ausreichend Metall entfernt wurde, wird das Ätzmittel und anschließend auch das Ätzresist entfernt. Das Ätzresist wird bevorzugt mit alkalischer Lösung enthaltend Natriumcarbonat oder Natriumhydroxid entfernt.

Die Verbindungsstege können die gesamte Fläche zwischen den Metallisierungsbereichen ausfüllen (Verbindungsfläche) oder es liegen neben den Verbindungsstegen auch Hohlstellen vor.

Hohlstellen sind dabei Bereiche des Metallblechs, in denen das Metall vollständig entfernt wurde. D.h. es handelt sich um ein Loch innerhalb der Fläche des Metallblechs. Eine Hohlstelle dient der Materialeinsparung und der Minimierung des Aufwandes zur Trennung der einzelnen Metallisierungen. Wird ein Bereich des Kupferblechs für das Design der Metallisierung bzw. die Handhabung (Verbindungsstege) nicht benötigt, kann dieser vor dem Aufbringen auf das Substrat vollständig entfernt werden. Die Entfernung des Metalls kann mit den Methoden zur Erzeugung einer Ausnehmung erfolgen.

Verbindungsstege und Metallisierungsbereiche werden in einer weiteren Ausgestaltung zusätzlich durch Unterbrechungen und/oder Ausnehmungen voneinander abgegrenzt, z.B. durch eine Perforationslinie oder eine Mikroperforation, d.h. eine Linie die kleine Hohlstellen aufweist. Sie werden ebenfalls durch die oben genannten Methoden erzeugt.

Der Begriff Aktivlot bezeichnet ein Lot, dem ein Aktivelement zulegiert wird. Aktivelemente sind dabei Metalle wie beispielsweise Titan oder Indium. Aktivlote sind bei erhöhten Temperaturen sauerstoffaffin und reagieren während der Lötung mit dem Sauerstoff der Oxidkeramik bzw. mit der Oxidschicht der Nicht-Oxid-Keramik. Bevorzugt werden titanhaltige Aktivlote eingesetzt, besonders bevorzugt Aktivlote umfassend AgCuTi4. Aktivlote sind pastös und weisen bevorzugt eine Viskosität von 10 - 30 Pa*s auf, besonders bevorzugt 14-20 Pa*s. Geeignete Lote weisen bevorzugt einen Metallgehalt von ≥ 75 Gew.-%, besonders bevorzugt ≥ 80 Gew.-% bezogen auf das Gesamtgewicht des Lots auf. Der Schmelzbereich des Lots liegt bevorzugt zwischen 600-1000°C, besonders bevorzugt zwischen 700-850°C. Die Dicke der Schicht aus dem Aktivlot (DL1, DL2, ...DLn) beträgt vorzugsweise 10-60 µm, wobei die Dicke der Aktivlotschicht im Bereich der einzelnen Metallisierungen gleich oder voneinander verschieden sein kann. Das Material des Aktivlots kann gleich oder voneinander verschieden sein.

Aktivlöten ist ein bekanntes Verfahren zum Verbinden unterschiedlicher Materialien und wird entsprechend dem Stand der Technik durchgeführt.

Die Metallisierung wird gemäß dem nachfolgend beschriebenen Verfahren auf das Substrat aufgebracht.

In einem ersten Verfahrensschritt wird das Substrat mit Aktivlot versehen. Dazu wird das Aktivlot nur auf den mindestens einen Bereich, in dem sich im finalen Produkt die Metallisierung befinden soll, aufgebracht, d.h. nur auf den Bereich bzw. die Bereiche des Substrats, auf denen im nachfolgenden Schritt die mindestens zwei Metallisierungsbereiche aufgebracht werden. Dementsprechend wird beispielsweise auf einer Leiterplatte nur auf die Positionen der zukünftigen Leiterbahnen das Aktivlot aufgebracht. Das Aktivlot wird gemäß dem finalen Designlayout der Metallisierung auf dem Substrat aufgebracht. Das Aktivlot wird bevorzugt mittels Siebdruck, Tintenstrahl oder Schablonendruck auf das Substrat aufgebracht.

Im zweiten Verfahrensschritt wird ein strukturiertes Metallblech (das Vorprodukt) auf das Substrat aufgebracht. Das Metallblech wird derart auf das Substrat aufgebracht, dass die Bereiche, in denen sich im finalen Produkt die Metallisierung befinden soll, mit dem Aktivlot in Verbindung gebracht werden. D.h., das Metallblech wird derart auf das Substrat aufgebracht, dass die Metallisierungsbereiche mit dem Aktivlot in Verbindung gebracht werden. Dabei ist vor allem auf eine genaue Positionierung zu achten, um sicherzustellen, dass sich die Metallisierungsbereiche vollständig auf dem Aktivlot befinden. Das Metallblech, bevorzugt das strukturierte und noch zusammenhängende Metallblech wird auf das Substrat aufgebracht, z.B. aufgelegt und bevorzugt in der Position fixiert, um ein Verrutschen zu vermeiden. Der Verfahrensschritt erfolgt bevorzugt in einer Lötform, beispielsweise aus Keramik, Stahl oder Graphit.

In einer alternativen Ausgestaltung wird im ersten Verfahrensschritt das Metallblech mit dem Aktivlot versehen. Dazu wird das Aktivlot nur auf den Metallisierungsbereich aufgebracht. In einer bevorzugten Ausgestaltung wird das Aktivlot auf ein bereits strukturiertes Metallblech aufgebracht, wobei das Aktivlot ebenfalls nur mit dem mindestens einen Metallisierungsbereich in Berührung kommt.

Das Aktivlot wird substratseitig auf das Metallblech aufgebracht. Das Aktivlot wird bevorzugt mittels Siebdruckes, Tintenstrahl oder Schablonendruck auf das Substrat aufgebracht. Im zweiten Verfahrensschritt wird das Metallblech, bevorzugt das strukturierte Metallblech, mit dem darauf aufgebrachten Aktivlot derart auf das Substrat aufgebracht, dass die Metallisierungsbereiche über das Aktivlot mit dem Substrat in Verbindung stehen. Das Aktivlot verbindet somit Substrat und Metallisierungsbereich. Das Metallblech, bevorzugt das strukturierte und noch zusammenhängende Metallblech, wird auf das Substrat aufgebracht, z.B. aufgelegt und bevorzugt in der Position fixiert, um ein Verrutschen zu vermeiden. Der Verfahrensschritt erfolgt bevorzugt in einer Lötform, beispielsweise aus Stahl oder Graphit.

Die ersten beiden Verfahrensschritte der beiden alternativen Ausgestaltungen können beidseitig des Substrats erfolgen.

Im dritten Verfahrensschritt wird die Verbindung Metall-Lot-Keramik erzeugt. Dazu wird zunächst das Aktivlot entbindert, bevorzugt bei 300-400°C, und/oder das Aktivlot zur Pyrolyse der organischen Bestandteile wie Binder, Weichmacher, etc. aufgeschmolzen, bevorzugt im Bereich von 600-1000°C, bevorzugt für 1-10 min im Vakuum zur Entfernung von Gasblasen zwischen den Metallisierungsbereichen und dem Aktivlot. Dieser Verfahrensschritt wird bevorzugt unter Inertgas bzw. Schutzgas, besonders bevorzugt unter Argon-Atmosphäre durchgeführt. Die Löttemperatur hängt vom gewählten Lot ab und beträgt bevorzugt 800-1100°C, besonders bevorzugt 850-1050°C. Bevorzugt erfolgt das Löten unter Aufbringung von Druck, z.B. unter Last in einer Lötform.

Im nächsten Verfahrensschritt werden die Verbindungsstege entfernt. Dies erfolgt mechanisch, bevorzugt durch Fräsen oder mittels eines Stichels, optisch, bevorzugt durch einen Laser, und/oder chemisch.

Das chemische Entfernen der Verbindungsstege erfolgt bevorzugt durch Ätzen mit einem Ätzmittel. Dabei wird ein Ätzresist auf die Metallisierungsbereiche aufgebracht, um diese vor dem Ätzmittel zu schützen. Die Verbindungsstege werden ausgespart. Bevorzugt erfolgt der Auftrag mittels Siebdruckes. Anschließend wird ein Ätzmittel, bevorzugt FeCl3, Na2S2O8 oder HCl auf die Verbindungsstege oder auf das gesamte Metallblech aufgebracht. Die nicht mit dem Ätzresist bedeckten Flächen werden durch das Ätzmittel entfernt. Da sich unter dem zu ätzenden Metallblech kein Aktivlot befindet, ist die Wirkung des Ätzmittels ausreichend. Anschließend wird das Ätzresist chemisch entfernt, bevorzugt mit alkalischer Lösung von Natriumcarbonat oder Natriumhydroxid.

Der finale Verbund aus mindestens einem Substrat und mindestens einer Metallisierung kann anschließend entnommen werden.

In einem optionalen Verfahrensschritt kann der Verbund weiter veredelt werden indem auf die Metallisierung weitere Metalle aufgebracht werden. Bevorzugt werden dabei Ni, Ag, Ni/Au und/oder Pd auf der Metallisierung abgeschieden.

In einem weiteren optionalen Verfahrensschritt wird die Dicke einer Metallisierung z.B. durch mechanischen Abtrag reduziert. Die Metallisierung weist in einer solchen Ausgestaltung eine geringere Höhe auf als der zugehörige Metallisierungsbereich.

Das erfindungsgemäße Verfahren bringt folgende Vorteile:
Die Metallisierung, bevorzugt Kupfer oder Aluminium, besonders bevorzugt Kupfer, wird frei von Poren an das Substrat, bevorzugt die Keramik gebunden. Daraus resultiert eine hohe Teilentladungsfestigkeit, die beim Betrieb mit hohen Spannungen vorteilhaft ist und die thermische Anbindung verbessert.

Das Verfahren ist einfach und schnell durchführbar. Das Vorprodukt bzw. das Metallblech, bzw. das vorstrukturierte Metallblech muss nur einmal ausgerichtet und aufgebracht werden. Auch komplexe Geometrien lassen sich mit geringem Aufwand realisieren. Das Verfahren vereinfacht die Positionierung der Leiterbahnen auf einer Leiterplatte, da nicht jede Leiterbahn einzeln aufgebracht wird, sondern die Summe der stabil miteinander verbundenen Leiterbahnen im vorstrukturierten Kupferblech.

Es entfällt ein aggressiver Ätzschritt zur Entfernung des Aktivlots, da das Aktivlot nur auf die dem Design entsprechenden Stellen aufgebracht wird. So kann auf weniger aggressive Methoden zur Entfernung der Verbindungsstege, bevorzugt aus Kupfer oder Aluminium, besonders bevorzugt Kupfer, zurückgegriffen werden.

Ein bevorzugtes Anwendungsgebiet ist die Herstellung von Leiterplatten mit Leiterbahnen für Leistungsmodule in Windkraftanlagen, Photovoltaikanlagen und Elektrofahrzeugen.

### Bezugszeichenliste

1 Verbund
2 Substrat, Trägerkörper
3 einteilige flächenförmige metallische Struktur, bevorzugt ein Metallblech
4 Aktivlot
5 Metallisierungsbereich (bevorzugt Leiterbahn)
55 Metallisierung
6 Verbindungssteg
7 lokale Ausdünnung auf der dem Substrat zugewandten Seite
8 lokale Ausdünnung auf der vom Substrat abgewandten Seite
9 Hohlstelle
10 zu entfernender Bereich des Metallblechs
11 zu entfernendes Lot
12 finales Produkt
13 kein Aktivlot
14 Perforationslinie

Nachfolgend wird die Erfindung anhand von Figuren weiter erläutert. Es zeigt:
Figur 1 zeigt einen Verbund nach Verfahrensschritt d.
Figur 2 zeigt einen anderen Verbund nach Verfahrensschritt d.
Figur 3 zeigt einen weiteren Verbund nach Verfahrensschritt d.
Figur 4 zeigt einen Verbund nach dem Stand der Technik.
Figur 5 zeigt eine Draufsicht des Verbundes nach Fig. 4.
Figur 6 zeigt eine Draufsicht eines Verbundes nach dem erfindungsgemäßen Verfahren.
Figur 7 zeigt einen Verbund nach dem erfindungsgemäßen Verfahren.
Figur 8 zeigt ein Vorprodukt, bzw. ein Metallblech 3 aus Kupfer.
Figur 9 zeigt einen Ausschnitt aus einem Vorprodukt bzw. eines Metallblechs 3

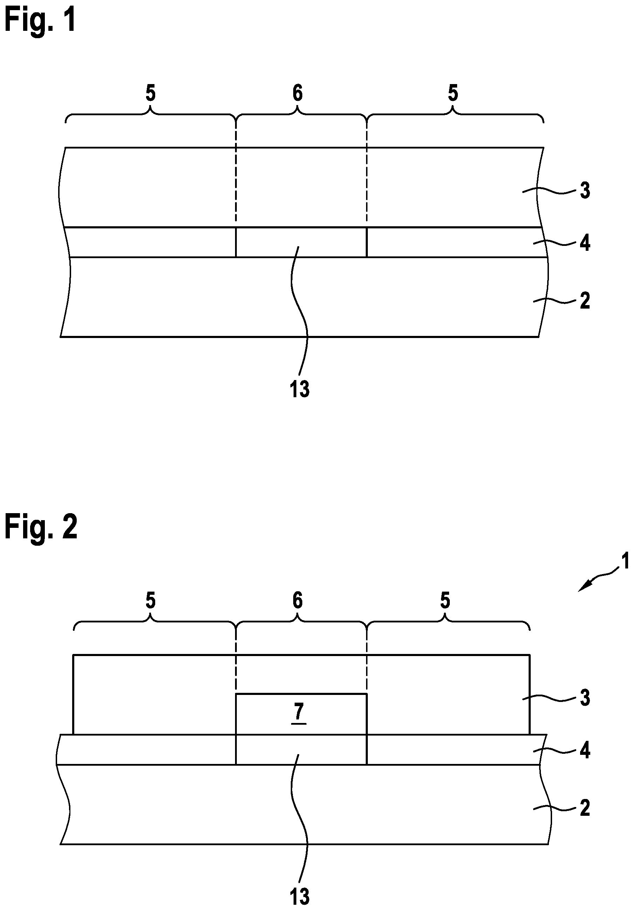

Figur 1 zeigt das Substrat 2 nach dem erfindungsgemäßen Verfahren nach dem gerichteten Aufbringen und Fixieren der Struktur auf dem Substrat und der Temperaturbehandlung, mit welcher das Aktivlot 4 und die einteilige, flächenförmige, metallische Struktur, in den Beispielen das Metallblech, 3 aufgelötet wurde. Mit Metallblech 3 ist allgemein das Vorprodukt gemeint. Das Metallblech 3 weist zwei Metallisierungsbereiche 5, d.h. Leiterbahnen und/oder Leiterflächen und einen Verbindungssteg 6 auf. Mit Verbindungssteg 6 ist auch eine Verbindungsfläche gemeint. Zwischen den Metallisierungsbereichen 5, die im finalen Produkt die Leiterbahnen und/oder Leiterflächen darstellen, und dem Substrat 2 befindet sich das Aktivlot 4. Zwischen dem Verbindungssteg 6 des Metallblechs 3, an dem im finalen Produkt keine Metallisierung vorhanden sein soll, und dem Substrat 2 befindet sich kein Aktivlot. Dieser Bereich ist mit dem Bezugszeichen 13 bezeichnet.

Figur 2 ähnelt Figur 1, zeigt jedoch eine lokale Ausdünnung 7 des Metallblechs 3. Auf das Substrat 2 wurde das strukturierte Metallblech 3 mit Hilfe des Aktivlots 4 aufgelötet. Das Metallblech 3 weist einen Verbindungssteg 6 auf, wobei sich zwischen dem Substrat 2 und dem Verbindungssteg 6 der Bereich der lokalen Ausdünnung 7, auf der dem Substrat zugewandten Seite befindet. In diesem Bereich 13 befindet sich auch kein Aktivlot. Zwischen den Metallisierungsbereichen 5 und dem Substrat 2 befindet sich das Aktivlot 4.

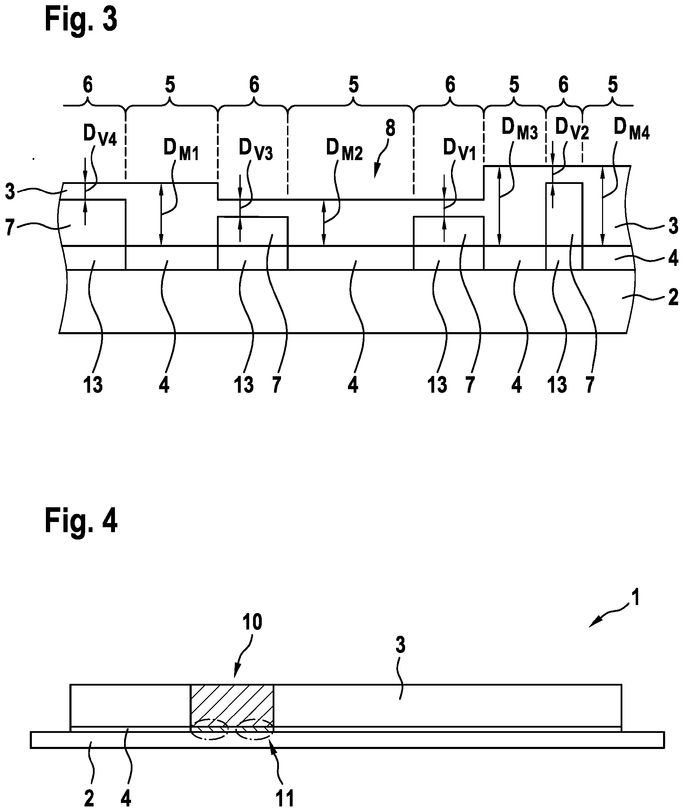

Figur 3 zeigt das Substrat 2 nach dem erfindungsgemäßen Verfahren nach dem gerichteten Aufbringen und Fixieren der Struktur auf dem Substrat und der Temperaturbehandlung, mit welcher das Aktivlot 4 und das Metallblech 3 aufgelötet wurde. In den Figuren 2 und 3 ist dargestellt, dass die Metallisierungsbereiche 5 unterschiedliche Dicken (DM1, DM2, ..., DMn) aufweisen können. Dabei ist zu beachten, dass alle Metallisierungsbereiche 5 über das Aktivlot 4 mit dem Substrat 2 in Verbindung stehen. Zwischen dem Substrat 2 und den Metallisierungsbereichen 5 liegen keine Bereiche der lokalen Ausdünnung auf der dem Substrat zugewandten Seite 7. Unterschiedliche Dicken der Metallisierungsbereiche 5 können über lokale Ausdünnung auf der vom Substrat abgewandten Seite 8 erzeugt werden. Die Verbindungsstege 6 können ebenfalls unterschiedliche Dicken aufweisen (DV1, DV2, ..., DVn) und sich in unterschiedlichen Höhen befinden.

Figur 4 zeigt einen Verbund nach dem Stand der Technik zu einem ähnlichen Zeitpunkt des AMB-Verfahrens. Das Metallblech 3 weist keinerlei Strukturierung auf und ist über ein Aktivlot 4 vollflächig mit dem Substrat 2 verbunden. Der zu entfernende Bereich des Metallblechs 10 ist über ebenfalls zu entfernendes Aktivlot 11 mit dem Substrat 2 verbunden.

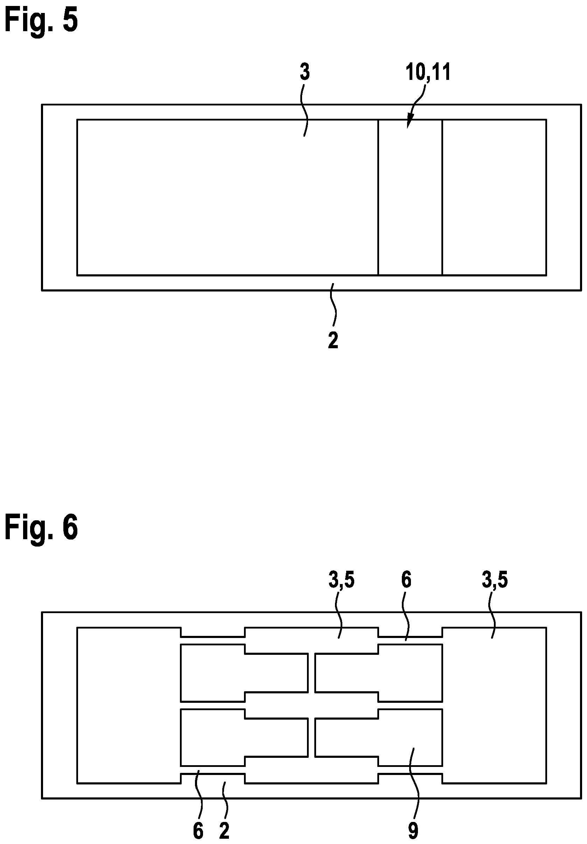

Figur 5 zeigt eine Draufsicht der Figur 4. Das Metallblech 3 weist auch hier keine Strukturierung auf und ist vollflächig über das Aktivlot mit dem Substrat 2 verbunden. Auch der zu entfernende Bereich des Metallblechs 10 ist über zu entfernendes Aktivlot 11 mit dem Substrat 2 verbunden. Aktivlot 11 an den Seiten muss ebenfalls entfernt werden.

Figur 6 zeigt eine Draufsicht eines Verbundes nach dem erfindungsgemäßen Verfahren. Das Metallblech 3 ist entsprechend dem Metallisierungsdesign vorstrukturiert. Die Verbindungsstege 6 verbinden die einzelnen Metallisierungsbereiche 5 zur vereinfachten Handhabbarkeit. Die Hohlstellen 9 wurden eingebracht, da an diesen Stellen kein Metall für das spätere Design benötigt wird. Das Aktivlot ist in dieser Draufsicht nicht sichtbar und befindet sich lediglich zwischen den Metallisierungsbereichen 5 und dem Substrat 2.

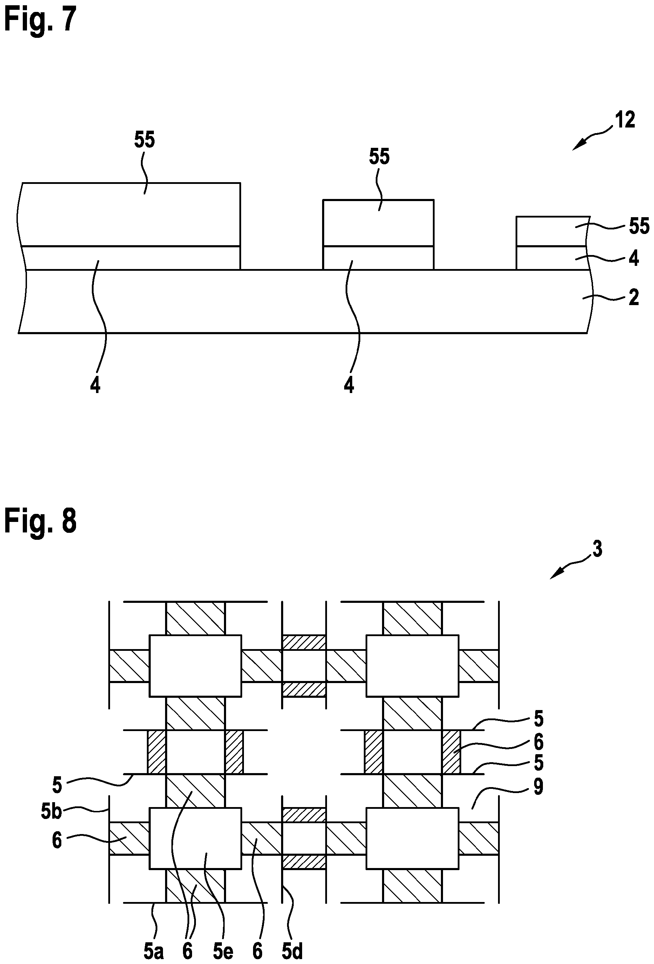

Figur 7 zeigt einen Verbund nach dem erfindungsgemäßen Verfahren. Auf dem Substrat 2 befinden sich die einzelnen Metallisierungen 55, die aus den Metallisierungsbereichen hervorgehen. Diese sind über das Aktivlot 4 mit dem Substrat 2 verbunden. Die Metallisierungen 55 weisen unterschiedliche Dicken auf. Die unterschiedlichen Dicken gehen in einer Ausgestaltung bereits aus dem strukturierten Metallblech hervor. Die in Figur 2 gezeigten unterschiedlichen Dicken der Metallisierungsbereiche 5 (Fig. 3) werden über lokale Ausdünnung auf der vom Substrat abgewandten Seite 8 (Fig. 3) erzeugt. In einer weiteren Ausgestaltung werden die unterschiedlichen Dicken erst nach dem Entfernen der Verbindungsstege z.B. durch mechanischen Abtrag erzeugt. Die Metallisierung 55 weist in einer solchen Ausgestaltung eine geringere Höhe auf als der zugehörige Metallisierungsbereich. Beide Ausgestaltungen sind miteinander kombinierbar.

Figur 8 zeigt ein Vorprodukt, bzw. ein Metallblech 3 aus Kupfer. Anhand dieser Figur wird gezeigt, dass die Metallisierungsbereiche 5, die auf dem fertigen Endprodukt die Metallisierungen 55, bevorzugte Leiterbahnen und/oder Leiterflächen, darstellen, eine einzige oder eine Mehrzahl an elektrischen Schaltungen darstellt/darstellen. Eine erste Schaltung (schematisch) besteht aus dem Metallisierungsbereich 5e. Um diese herum sind als Leiterbahnen ausgebildete Metallisierungsbereiche 5a, 5b und 5d angeordnet. Damit sich ein Zusammenhalt ergibt, sind die Metallisierungsbereiche 5 durch Verbindungsstege 6 voneinander getrennt. Figur 8 zeigt vier gleiche Schaltungen bzw. Schaltungsdesigns. Es sei betont, dass diese Figur nur schematisch ein Vorprodukt zeigt.

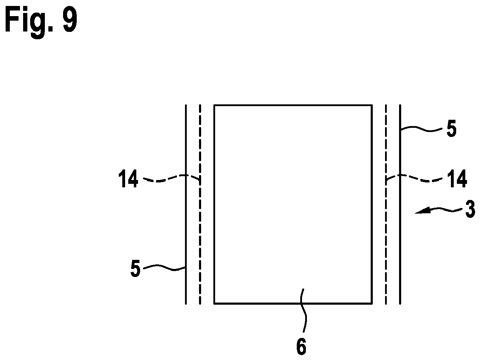

Figur 9 zeigt einen Ausschnitt aus einem Vorprodukt bzw. eines Metallblechs 3. Zwei als Leiterbahnen vorgesehene Metallisierungsbereiche 5 sind durch einen Verbindungssteg 6 miteinander verbunden. Wie schon ausgeführt, wird mit Verbindungssteg 6 immer auch eine Verbindungsfläche bezeichnet. Damit sich die Verbindungsstege 6 leichter von den Metallisierungsbereichen 5 trennen lassen, sind diese über eine Perforationslinie 14 mit den Metallisierungsbereichen 5 verbunden.

## Patentansprüche

1. Einteilige, flächenförmige, metallische Struktur (3), **dadurch gekennzeichnet, dass** diese als Vorprodukt für elektrische Schaltungen aus Leiterbahnen und/oder Leiterflächen, besteht und zwischen dem mindestens einem Metallisierungsbereich (5) an geeigneten Stellen mindestens ein Verbindungssteg (6) für die Stabilisierung und Handhabbarkeit der Struktur (3) angeordnet sind.

2. Struktur nach Anspruch 1, **dadurch gekennzeichnet, dass** die Struktur (3) aus Kupfer oder kupferhaltigen Legierungen oder Aluminium oder aluminiumhaltigen Legierungen besteht.

3. Struktur nach Anspruch 1 oder 2, **dadurch gekennzeichnet, dass** der Raum innerhalb bzw. zwischen dem mindestens einem Metallisierungsbereich (5) vollständig mit dem mindestens einem Verbindungssteg (6) ausgefüllt ist, so dass die Struktur (3) eine geschlossene Fläche ohne Durchbrüche bildet.

4. Struktur nach einem der Ansprüche 1 bis 3, **dadurch gekennzeichnet, dass** der mindestens eine Metallisierungsbereich (5) eine einzige oder eine Mehrzahl an elektrischen Schaltungen darstellt/darstellen.

5. Struktur nach einem der Ansprüche 1 bis 4, **dadurch gekennzeichnet, dass** der Verbindungssteg (6) eine gleiche oder geringere Dicke als der anschließenden Metallisierungsbereich (5) aufweisen.

6. Struktur nach einem der Ansprüche 1 bis 5, **dadurch gekennzeichnet, dass** der Verbindungssteg (6) zur Oberseite und/oder Unterseite der Struktur (3) einen Abstand aufweisen und dieser unterschiedlich und auch Null sein kann, d.h. der Verbindungssteg (6) zu einer Seite bündig angeordnet ist und zur anderen Seite einen Abstand aufweist.

7. Struktur nach einem der Ansprüche 1 bis 6, **dadurch gekennzeichnet, dass** die Metallisierungsbereiche (5) eine voneinander unterschiedliche Dicke aufweisen.

8. Struktur nach einem der Ansprüche 1 bis 7, **dadurch gekennzeichnet, dass** der Abstand zwischen zwei benachbarten Metallisierungsbereichen (5) mindestens 50 µm beträgt.

9. Verfahren zur Herstellung einer elektrischen Schaltung auf einem Substrat (2), **dadurch gekennzeichnet, dass** die einteilige, flächenförmige, metallische Struktur (3) nach einem der Ansprüche 1 bis 8 ausschließlich mittels Metallisierungsbereich (5) auf dem Substrat (2) befestigt wird und anschließend der mindestens eine Verbindungssteg (6) der Struktur (3) entfernt werden.

10. Verfahren nach Anspruch 9, **dadurch gekennzeichnet, dass** das Substrat (2) aus einer Keramik ist

11. Verfahren nach Anspruch 10, **dadurch gekennzeichnet, dass** die Struktur (3) auf dem Substrat (2) an dem Metallisierungsbereich (5) mit dem AMB-Verfahren befestigt wird.

12. Verfahren nach Anspruch 11, **dadurch gekennzeichnet, dass** ausschließlich die Flächen auf dem Substrat (2), auf denen der Metallisierungsbereich (5) der Struktur (3) befestigt werden sollen, mit Aktivlot versehen werden.

13. Verfahren nach Anspruch 11, **dadurch gekennzeichnet, dass** der Metallisierungsbereich (5) der Struktur (3) auf der zum Substrat (2) gewandten Seite mit Aktivlot versehen werden.

14. Verfahren nach einem der Ansprüche 11 bis 13 zur Herstellung einer elektrischen Schaltung auf einem Substrat (2) aus einer Keramik mit dem AMB-Verfahren umfassend folgende Verfahrensschritte
a) Bereitstellen der Struktur (3) mit mindestens einem Metallisierungsbereich (5) und mindestens einem Verbindungssteg (6) und des Substrats (2)
b) Aufbringen des Aktivlots (4) ausschließlich auf den Flächen des Substrats (2), auf denen der Metallisierungsbereich (5) der Struktur (3) befestigt werden sollen oder auf den Metallisierungsbereich (5) der Struktur (3) auf der zum Substrat (2) gewandten Seite,
c) Gerichtetes Aufbringen und Fixieren der Struktur (3) auf das Substrat (2), so dass nur der Metallisierungsbereich (5) der Struktur (3) über das Aktivlot (4) mit der zu metallisierenden Fläche des Substrats (2) in Verbindung steht
d) Temperaturbehandlung des gesamten Verbunds bei Temperaturen oberhalb der Aktivierungstemperatur des Aktivlots (4) zur Erzeugung der Verbindung Metallisierungen-Aktivlot-Substrat,
e) Entfernen des mindestens einem Verbindungsstegs (6),
f) Entnahme des Verbunds.
